# EUROPÄISCHE PATENTANMELDUNG

(11) **EP 3 726 234 A1**
(43) Veröffentlichungstag der Anmeldung: **21.10.2020**
(21) Anmeldenummer: 20166980.1
(22) Anmeldetag: 31.03.2020
(51) Int. Cl.: G01R 31/34

(54) **VERFAHREN ZUR DIAGNOSE EINES ELEKTROMOTORS**

(30) Priorität: 17.04.2019 DE 102019205561
(71) Anmelder: Robert Bosch GmbH, 70442 Stuttgart (DE)
(72) Erfinder: Kessler, Martin, 73527 Schwaebisch Gmuend (DE); Ries-Mueller, Klaus, 74906 Bad Rappenau (DE)

(57) **Zusammenfassung**

Die Erfindung betrifft ein Verfahren zur Diagnose eines Elektromotors (10), der einen Rotor (12) und einen Stator (14) aufweist. Dabei ist ein Wechselrichter (20) ausgangsseitig mit dem Elektromotor (10) elektrisch verbunden. Zur Messung von Phasenströmen des Elektromotors (10) umfasst der Wechselrichter (20) Stromsensoreinrichtungen (30), die jeweils einer Phase des Elektromotors (10) zugeordnet sind. Dabei weisen die Stromsensoreinrichtungen (30) jeweils mindestens zwei Magnetfeldsensoren (32, 34) auf. Die Erfindung betrifft ferner eine elektrische Antriebseinheit (100), die zur Durchführung des erfindungsgemäßen Verfahrens eingerichtet ist. Die Erfindung betrifft auch ein Kraftfahrzeug, welches zur Durchführung des erfindungsgemäßen Verfahrens eingerichtet ist und/oder mindestens eine solche elektrische Antriebseinheit (100) umfasst.

## Beschreibung

Die Erfindung betrifft ein Verfahren zur Diagnose eines Elektromotors, der einen Rotor und einen Stator aufweist. Dabei ist ein Wechselrichter ausgangsseitig mit dem Elektromotor elektrisch verbunden. Zur Messung von Phasenströmen des Elektromotors umfasst der Wechselrichter Stromsensoreinrichtungen, die jeweils einer Phase des Elektromotors zugeordnet sind. Dabei weisen die Stromsensoreinrichtungen jeweils mindestens zwei Magnetfeldsensoren auf. Die Erfindung betrifft ferner eine elektrische Antriebseinheit, die zur Durchführung des erfindungsgemäßen Verfahrens eingerichtet ist. Die Erfindung betrifft auch ein Kraftfahrzeug, welches zur Durchführung des erfindungsgemäßen Verfahrens eingerichtet ist und/oder mindestens eine solche elektrische Antriebseinheit umfasst.

### Stand der Technik

Es zeichnet sich ab, dass zukünftig vermehrt elektrisch angetriebene Kraftfahrzeuge zum Einsatz kommen werden. Solche elektrisch angetriebenen Kraftfahrzeuge, wie z. B. Elektrofahrzeuge und Hybridfahrzeuge, umfassen jeweils mindestens eine elektrische Antriebseinheit, welche einen Elektromotor und einen Wechselrichter aufweist. Dabei wird der Wechselrichter in räumlicher Nähe zum Elektromotor angeordnet, wie beispielsweise direkt an bzw. auf ein Gehäuse des Elektromotors angebracht oder in das Gehäuse des Elektromotors installiert, da dadurch u. a. Kabel und Stecker eingespart werden und somit das Gewicht des Kraftfahrzeugs reduziert wird. Vorzugsweise werden dabei der Elektromotor, der Wechselrichter und ein Getriebe zu einer elektrischen Antriebsachse kombiniert.

Zur Steuerung und Regelung des Elektromotors weist der Wechselrichter üblicherweise Stromsensoreinrichtungen auf, welche unter anderem die jeweiligen Phasenströme basierend auf Magnetfeldmessung durch Magnetfeldsensoren der Stromsensoreinrichtungen messen. Dabei werden die Phasenströme des Elektromotors mittels Frequenzanalyse ausgewertet. Der Wechselrichter kann auch Stromsensoreinrichtungen zur Messung eines Eingangsstroms des Wechselrichters umfassen.

Fehlerfälle des Elektromotors verursachen meist charakteristische Amplituden des Frequenzspektrums und Phasenverschiebungen des Phasenstroms des Elektromotors, deren Auswertungen zur Fehlerklassifizierung herangezogen werden. Beispielsweise verursachen Unwuchten des Elektromotors Amplituden des Frequenzspektrums proportional zur Drehzahl des Elektromotors.

Der Artikel von W. T.Thomson und R. J. Gilmore, Motor current signature analysis to detect faults in induction motor drives - fundamentals, data interpretation, and industrial case histories, Proceedings of the thirty-second turbomachinery symposium, 2003, Seiten 145 bis 156, und der Artikel von E. Artigao, T. Chatziloukas, et al., Condition Monitoring System für die Zustandsüberwachung der rotierenden Komponenten einer Windkraftanlage, DGZfP-Jahrestagung 2014 - Poster43, Seiten 1 bis 6, beschreiben jeweils ein Verfahren zur Diagnose eines Fehlverhaltens in einem Induktionsmotor. Dabei wird der Motorstrom aufgenommen und anschließend werden mit Signalverarbeitung und Signalanalyse unterschiedliche Fehler diagnostiziert.

Das Dokument US 2011/0204889 A1 beschreibt einen Stromsensor mit hoher Genauigkeit und geringem Stromverbrauch über einen großen Messbereich. Dabei umfasst der Stromsensor zwei Magnetfeldsensorelemente zur Unterdrückung der Störung des Erdmagnetfelds bei der Strommessung.

### Offenbarung der Erfindung

Es wird ein Verfahren zur Diagnose eines Elektromotors, der einen Rotor und einen Stator aufweist, mit dem Merkmal des Anspruchs 1 vorgeschlagen.

Der Elektromotor kann ein- oder mehrphasig ausgeführt werden. Beispielsweise kann der Elektromotor als ein dreiphasiger Traktionsmotor eines Elektro- oder Hybridfahrzeugs ausgebildet werden. Es ist aber auch denkbar, dass der Elektromotor ein Servomotor für ein elektrisches Lenksystem oder für einen elektromechanischen Bremskraftverstärker oder auch ein Industrieantriebsmotor ist. Der Elektromotor kann als eine permanentmagneterregte Synchronmaschine (PSM) ausgebildet werden.

Zur Steuerung bzw. Regelung des Elektromotors ist ein Wechselrichter ausgangsseitig mit dem Elektromotor elektrisch verbunden. Der Wechselrichter ist dabei in räumlicher Nähe zu dem Elektromotor angeordnet. Beispielsweise kann der Wechselrichter auf bzw. an einem Gehäuse des Elektromotors angebracht oder in dem Gehäuse des Elektromotors installiert werden.

Zur Messung von Phasenströmen des Elektromotors umfasst der Wechselrichter Stromsensoreinrichtungen, die jeweils einer Phase des Elektromotors zugeordnet sind und die Phasenströme basierend auf Magnetfeldmessung messen. Die Phasenströme des Elektromotors werden dabei durch die Stromsensoreinrichtungen mittels hochfrequenter Abtastung gemessen. Bevorzugt ist die Abtastungsfrequenz größer als 100 kHz.

Aufgrund der räumlichen Nähe des Wechselrichters zum Elektromotor stellen Magnetfelder, die der Elektromotor im Betrieb abgibt, wie beispielsweise ein Drehfeld, das durch Spulen des Stators des Elektromotors erzeugt wird sowie ein Magnetfeld, das durch Permanentmagnete des Rotors des als eine PSM ausgebildeten Elektromotors erzeugt wird, außer dem Erdmagnetfeld bei der Strommessung Störfelder dar.

Unter räumlicher Nähe des Wechselrichters zum Elektromotor wird daher insbesondere verstanden, dass die Magnetfelder, die der Elektromotor im Betrieb abgibt, aufgrund eines Abstands zwischen dem Wechselrichter und dem Elektromotor durch die Stromsensoreinrichtungen des Wechselrichters erfasst werden können.

Damit die oben genannten Störfelder bei der Messung der Phasenströme des Elektromotors kompensiert werden können und die Phasenströme demzufolge präzise gemessen werden können, weisen die Stromsensoreinrichtungen jeweils mindestens zwei Magnetfeldsensoren auf.

Die mindestens zwei Magnetfeldsensoren messen dabei eine Komponente eines Magnetfelds, die senkrecht zu den mindestens zwei Magnetfeldsensoren gerichtet ist. Beispielsweise können zwei Magnetfeldsensoren zu einer stromdurchflossenen Leiterbahn so angeordnet werden, dass bei Störfeldern die senkrecht zu den mindestens zwei Magnetfeldsensoren gerichteten Komponenten in den mindestens zwei Magnetfeldsensoren den gleichen Betrag und das gleiche Vorzeichen besitzen, während sie beim Magnetfeld des Phasenstroms des Elektromotors entgegengesetzte Vorzeichen haben. Durch eine Differenzbildung von Messsignalen der mindestens zwei Magnetfeldsensoren können die Störfelder bei der Messung der Phasenströme kompensiert werden.

Die mindestens zwei Magnetfeldsensoren können dabei jeweils eine Messzelle aufweisen. Die mindestens eine Messzelle kann als ein Hallelement ausgebildet sein. Anstelle von Hallelementen können TMR-Elemente (englisch: tunnel magnetoresistance, TMR) oder GMR-Elemente (englisch: giant magnetoresistance, GMR) eingesetzt werden. Die mindestens zwei Magnetfeldsensoren können jeweils weitere Messzellen aufweisen, die gleichzeitig jeweils weitere Dimensionen bzw. Richtungen des Magnetfeldes erfassen. Beispielsweise können die mindestens zwei Magnetfeldsensoren jeweils drei Messzellen für alle drei Dimensionen aufweisen.

Die Stromsensoreinrichtungen können jeweils eine Platine aufweisen, auf welcher die mindestens zwei Magnetfeldsensoren angeordnet sind. Die Stromsensoreinrichtungen können auch jeweils Schaltungen zur Auswertung von Messsignalen der mindestens zwei Magnetfeldsensoren und zur Energieversorgung der Stromsensoreinrichtung umfassen.

Erfindungsgemäß wird zunächst ein zeitlicher Verlauf durch Addieren von Messsignalen der mindestens zwei Magnetfeldsensoren von mindestens einer der Stromsensoreinrichtungen zur Ermittlung der Magnetfelder des Elektromotors über eine vorbestimmte Anzahl von Umdrehungen des Rotors des Elektromotors, wie z.B. 10 Umdrehungen, erfasst. Dabei werden die Drehzahl und die Drehlage des Rotors des Elektromotors stets erfasst. Im Gegensatz zur Strommessung wird das Magnetfeld des Phasenstroms des Elektromotors durch Addieren der Messsignale der mindestens zwei Magnetfeldsensoren von mindestens einer der Stromsensoreinrichtungen kompensiert. Das stationäre Erdmagnetfeld kann dabei durch eine Filterung eliminiert werden.

Bevorzugt wird der zeitliche Verlauf bei einer günstigen Betriebsbedingung des Elektromotors erfasst. Unter einer günstigen Betriebsbedingung ist zu verstehen, dass sich der Elektromotor beispielsweise nicht in einer Beschleunigungs- oder eine Bremsphase mit hoher Dynamik befindet. Bevorzugt wird eine Betriebsbedingung als günstig angesehen, wenn eine Änderung der Drehzahl des Elektromotors kleiner als 500 Umdrehungen pro Minute pro Sekunde ist. Besonders bevorzugt wird eine Betriebsbedingung als günstig angesehen, wenn eine Änderung der Drehzahl des Elektromotors kleiner als 200 Umdrehungen pro Minute pro Sekunde ist. Ganz bevorzugt wird eine Betriebsbedingung als günstig angesehen, wenn die Drehzahl des Elektromotors konstant ist. Es ist aber auch denkbar, dass eine geringe Laständerung des Elektromotors als eine günstige Betriebsbedingung angesehen wird.

Anschließend wird ein Frequenzspektrum des durch Addieren der Messsignale der mindestens zwei Magnetfeldsensoren erfassten zeitlichen Verlaufs ermittelt. Die Ermittlung des Frequenzspektrums kann beispielsweise über eine Umdrehung des Rotors des Elektromotors erfolgen.

Danach wird das ermittelte Frequenzspektrum des durch Addieren der Messsignale der mindestens zwei Magnetfeldsensoren erfassten zeitlichen Verlaufs mit Frequenzspektren von typischen Fehlern des Elektromotors, welche in einem Steuergerät des Elektromotors gespeichert werden können, verglichen und Ähnlichkeitswerte dazwischen werden ermittelt. Hierbei können beispielsweise Differenzen bei einer gleichen Frequenz zwischen dem ermittelten Frequenzspektrum des zeitlichen Verlaufs und den Frequenzspektren der typischen Fehler des Elektromotors gebildet werden. Bei einer vollständigen Übereinstimmung des Frequenzspektrums des zeitlichen Verlaufs mit einem Frequenzspektrum eines typischen Fehlers, ist der Ähnlichkeitswert gleich Null.

Anschließend werden die Ähnlichkeitswerte mit einem vorgegebenen Schwellenwert, der größer als Null ist, verglichen. Wenn die Ähnlichkeitswerte kleiner als der vorgegebene Schwellenwert sind, werden Fehler des Elektromotors erkannt.

Die Erfassung des zeitlichen Verlaufs durch Addieren der Messsignale der mindestens zwei Magnetfeldsensoren und/oder die Ermittlung des Frequenzspektrums des durch Addieren der Messsignale der mindestens zwei Magnetfeldsensoren erfassten zeitlichen Verlaufs können mehrmalig durchgeführt werden und anschließend wird eine Mittelung des Ergebnisses der mehrmaligen Ermittlung des Frequenzspektrums ausgeführt.

Vorzugsweise werden nach Erkennen des Fehlers des Elektromotors eine oder mehrere Maßnahmen je nach Schwere des Fehlers eingeleitet. Beispielsweise kann der Fehler des Elektromotors in einem Fehlerspeicher gespeichert werden. Dabei kann der Fehlerspeicher ein Teil des Steuergeräts des Elektromotors sein. Des Weiteren kann eine Fehlerlampe angesteuert werden und/oder die Drehzahl des Elektromotors reduziert werden.

Vorteilhaft kann der Elektromotor eine Bezugsmarke für eine Messung der Phasenströme des Elektromotors und/oder für eine Messung der Drehzahl des Elektromotors aufweisen. Mithilfe der Bezugsmarke kann eine Lageinformation über 360° einer Umdrehung des Rotors erfasst werden. Mit dieser Lageinformation lässt sich feststellen, welche Spule des Elektromotors oder welcher Magnet des Rotors des als PSM ausgebildeten Elektromotors genau defekt ist.

Vorzugsweise werden eine Änderung und/oder ein Gradient der Änderung des ermittelten Frequenzspektrums des durch Addieren der Messsignale der mindestens zwei Magnetfeldsensoren erfassten zeitlichen Verlaufs ermittelt. Dabei kann das ermittelte Frequenzspektrum des durch Addieren der Messsignale der mindestens zwei Magnetfeldsensoren erfassten zeitlichen Verlaufs auf einem Speichermedium gespeichert werden. Beispielsweise kann das ermittelte Frequenzspektrum in dem Steuergerät gespeichert werden. Das ermittelte Frequenzspektrum kann aber auch in einem Cloud-Speicher online gespeichert werden. Bei langsamen Änderungen wird eine übliche Alterung des Elektromotors vermutet. Bei schnellen Änderungen wird von einer zunehmenden Schädigung des Elektromotors ausgegangen.

Vorzugsweise werden die Ähnlichkeitswerte zwischen dem ermittelten Frequenzspektrums des durch Addieren der Messsignale der mindestens zwei Magnetfeldsensoren erfassten zeitlichen Verlaufs und den Frequenzspektren der typischen Fehler des Elektromotors unter Zuhilfenahme von neuronalen Netzen ermittelt. Neuronale Netze haben den Vorteil, dass die Fehlerfälle vorab in einer Applikationsphase des Elektromotors gelernt werden können. Hierbei werden Messdaten an einem Prüfstand erfasst und abhängt von den Messdaten die Schwellenwerte angepasst.

Vorteilhaft kann das Frequenzspektrum des durch Addieren der Messsignale der mindestens zwei Magnetfeldsensoren erfassten zeitlichen Verlaufs unter Zuhilfenahme eines Cloud-Servers ermittelt werden, falls eine schnelle Datenleitung wie ein Mobilfunknetz, wie beispielsweise ein UMTS- oder ein LTE-Netz, zur Übertragung eines Drehzahlsignals des Elektromotors vorliegt.

Vorzugsweise wird das erfindungsgemäße Verfahren auf eine Messung eines Wechselstroms angewendet. Es ist aber auch denkbar, dass das erfindungsgemäße Verfahren auf eine Messung eines Gleichstroms angewendet wird.

Mit dem erfindungsgemäßen Verfahren kann beispielsweise ein fehlender oder reduzierter Drehmomentbeitrag eines Magnets oder mehrerer Magnete des Rotors des als PSM ausgebildeten Elektromotors und/oder einer Spule oder mehrerer Spulen des Stators des Elektromotors erkennt werden. Dieser Fehler führt zu charakteristischen Drehmomentschwankungen bzw. Einbrüchen, die sich im Drehzahlverlauf wieder spiegeln. Durch eine zusätzliche Auswertung einer Phasenverschiebung des Phasenstroms kann auf die Lage des defekten Magnets oder der defekten Spule geschlossen werden.

Vorteilhaft kann eine Unwucht des Elektromotors erkannt werden. Dies kann z.B. durch Bauteiltoleranzen oder auch durch Alterungseffekte, insbesondere Alterungseffekte von Lagern des Elektromotors, entstehen.

Ferner kann ein Lagerschaden erkannt werden. Aufgrund von Funkenüberschlägen kann es zu einer schleichenden Schädigung des Kugellagers des Elektromotors kommen. Dies führt zu geringen Drehzahlschwankungen bzw. Vibrationen, die je nach Höhe der Schädigung auch zu Magnetfeldänderungen führen. Hierbei können auch Beschleunigungssensoren eingesetzt werden, die zunehmende Vibrationen erkennen und dann unter Umständen eine Wartung des Elektromotors, wie beispielsweise einen Austausch eines geschädigten Kugellagers oder einen Austausch des Elektromotors, einleiten.

Weiterhin kann mit dem erfindungsgemäßen Verfahren eine Asymmetrie bei zwei unabhängig geschalteten Wechselrichtern, wie z.B. bei einem sechsphasigen Elektromotor und zwei dreiphasigen Wechselrichtern erkannt werden.

Mit dem erfindungsgemäßen Verfahren lässt sich eine Asymmetrie in einem Magnetfeldverlauf, die wiederum zu Drehmomentschwankungen führen kann, erkennen.

Ferner können Magnetfeldschwankungen abhängig von verschiedenen Ansteuerverfahren des Elektromotors gemessen werden. Beispielsweise können die Magnetfeldschwankungen im Blockbetrieb des Wechselrichters bei verschiedenen Taktfrequenzen erkannt werden.

Zur Kontrolle bzw. Überwachung einer Ansteuerung des Elektromotors kann die Höhe des Drehmomentes des Elektromotors mit dem erfindungsgemäßen Verfahren bestimmt werden. Vorzugsweise erfolgt diese Bestimmung bei niederen Drehzahlen des Elektromotors, wie z.B. beim Anfahren des Elektromotors. Das Drehmoment des Elektromotors wird hierbei indirekt über das Magnetfeld des Phasenstroms des Elektromotors bestimmt. Je größer das Drehmoment des Elektromotors ist, desto größer ist die Stärke des Phasenstroms und somit die Stärke des Magnetfelds des Phasenstroms.

Wenn beispielsweise ein zusätzlicher Permanentmagnet an einer bestimmten Position des Rotors des Elektromotors eingebaut wird, kann diese Position des Rotors mit dem erfindungsgemäßen Verfahren bestimmt werden. Das Magnetfeld des zusätzlichen Permanentmagnets wird bei einer Umdrehung des Rotors erkannt und zur Bestimmung der Rotorlage des Elektromotors verwendet. Alternativ kann der zusätzliche Permanentmagnet an einer Position des Stators des Elektromotors eingebaut werden.

Darüber hinaus können Funkenüberschläge innerhalb des Wechselrichters erkannt werden, da diese zu hohen, sich schnell ändernden Magnetfeldern führen.

Es wird ferner eine elektrische Antriebseinheit vorgeschlagen, die zur Durchführung des erfindungsgemäßen Verfahrens eingerichtet ist. Die Antriebseinheit umfasst einen Elektromotor und einen Wechselrichter. Dabei ist der Wechselrichter ausgangsseitig mit dem Elektromotor elektrisch verbunden. Der Wechselrichter weist ferner Stromsensoreinrichtungen zur Messung von Phasenströmen des Elektromotors auf. Die Stromsensoreinrichtungen zur Messung der Phasenströme des Elektromotors sind jeweils einer Phase des Elektromotors zugeordnet und umfassen jeweils mindestens zwei Magnetfeldsensoren.

Es wird auch ein Kraftfahrzeug, welches zur Durchführung des erfindungsgemäßen Verfahrens eingerichtet ist und/oder das mindestens eine oben beschriebene elektrische Antriebseinheit umfasst, vorgeschlagen.

### Vorteile der Erfindung

Bei dem erfindungsgemäßen Verfahren werden die Stromsensoreinrichtungen eines ausgangsseitig mit einem Elektromotor elektrisch verbundenen Wechselrichters, die zur Messung von Phasenströmen des Elektromotors verwendet werden und jeweils mindestens zwei Magnetfeldsensoren zur Kompensation von Störfeldern aufweisen, ausgenutzt. Da der Wechselrichter in räumlicher Nähe zum Elektromotor angeordnet ist, können mit den mindestens zwei Magnetfeldsensoren sowohl Magnetfelder von Phasenströmen des Elektromotors, als auch die Magnetfelder des Elektromotors, die von Spulen oder Magneten des Elektromotors erzeugt werden, erfasst werden. Es sind daher keine weiteren Messgeräte oder Maßnahmen zur Erfassung der Störfelder erforderlich.

Mit dem erfindungsgemäßen Verfahren können Fehler sowie Veränderungen eines Elektromotors durch Diagnose des Elektromotors im Betrieb erkannt werden. Somit kann der Elektromotor stets überwacht werden.

Vorteilhaft können mit dem erfindungsgemäßen Verfahren irreversible Schäden des Elektromotors verhindert werden und damit können Ausfälle des Antriebs verhindert werden.

### Kurze Beschreibung der Zeichnungen

Ausführungsformen der Erfindung werden anhand der Zeichnungen und der nachfolgenden Beschreibung näher erläutert.

Es zeigen:
- Figur 1: eine schematische Darstellung einer elektrischen Antriebseinheit,
- Figur 2: eine schematische Darstellung eines Wechselrichters der elektrischen Antriebseinheit,
- Figur 3: eine schematische Darstellung einer Stromsensoreinrichtung,
- Figur 4: ein Beispiel eines Frequenzspektrums eines Phasenstroms des Elektromotors,
- Figur 5a: ein Frequenzspektrum eines ersten typischen Fehlerfalls,
- Figur 5b: ein Frequenzspektrum eines zweiten typischen Fehlerfalls und
- Figur 5c: ein Frequenzspektrum eines dritten typischen Fehlerfalls.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

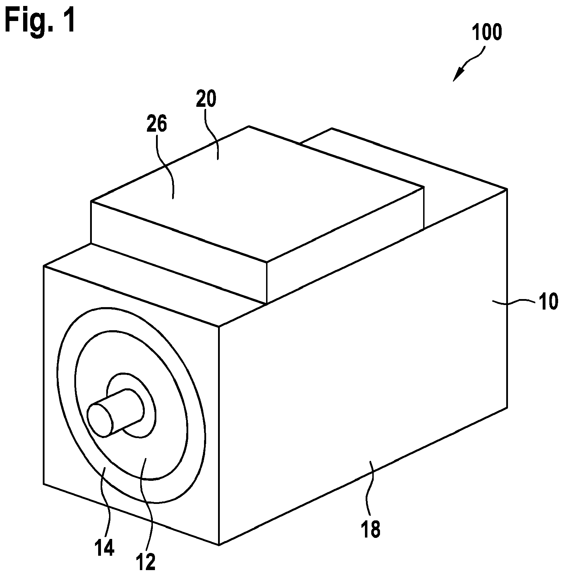

Figur 1 zeigt eine schematische Darstellung einer elektrischen Antriebseinheit 100, die zur Durchführung des erfindungsgemäßen Verfahrens eingerichtet ist. Dabei umfasst die elektrische Antriebseinheit 100 einen Elektromotor 10 und einen Wechselrichter 20. Der Elektromotor 10 umfasst einen Rotor 12 und einen Stator 14 und kann ein- oder mehrphasig ausgeführt werden. Dabei sind der Rotor 12 und der Stator 14 in einem Gehäuse 18 des Elektromotors 10 angeordnet. Der Elektromotor 10 kann als eine permanentmagneterregte Synchronmaschine (PSM) ausgebildet werden. Dabei umfasst der Stator 14 des Elektromotors 10 Spulen zur Erzeugung eines Drehfelds, und der Rotor 12 des Elektromotors 10 weist Permanentmagnete auf. Vorliegend ist der Wechselrichter 20 an bzw. auf dem Gehäuse 18 des Elektromotors 10 angebracht und ausgangsseitig mit dem Elektromotor 10 elektrisch verbunden. Dabei umfasst der Wechselrichter 20 ein eigenes Gehäuse 26. Es ist auch denkbar, dass der Wechselrichter 20 im Gehäuse 18 des Elektromotors 10 installiert wird, ohne ein eigenes Gehäuse 26 zu brauchen.

Die elektrische Antriebseinheit 100 kann in ein Kraftfahrzeug eingesetzt werden. Beispielsweise kann der Elektromotor 10 als ein Traktionsmotor eines Elektro- oder Hybridfahrzeugs ausgebildet werden. Es ist aber auch denkbar, dass der Elektromotor 10 ein Servomotor für ein elektrisches Lenksystem oder für einen elektromechanischen Bremskraftverstärker ist. Die elektrische Antriebseinheit 100 kann auch in einem Industrieantrieb eingesetzt werden.

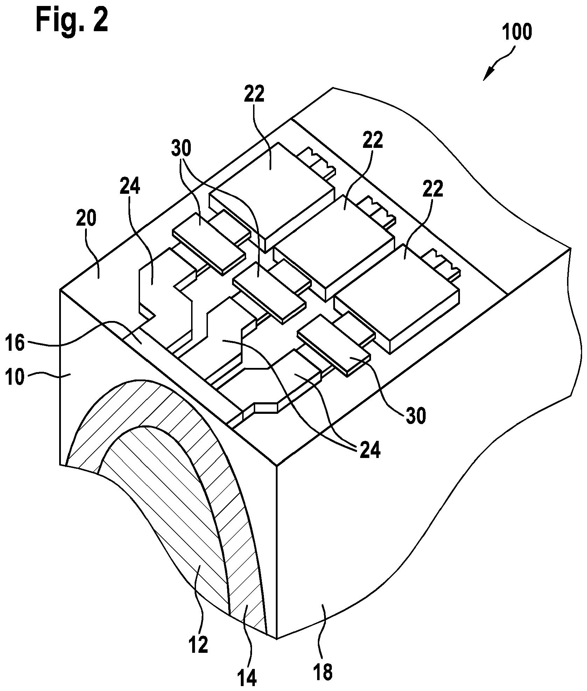

Figur 2 zeigt eine schematische Darstellung eines Wechselrichters 20 und eines Teils des Elektromotors 10 der elektrischen Antriebseinheit 100. Dabei sind der Elektromotor 10 sowie der Wechselrichter 20 dreiphasig ausgeführt.

Der Wechselrichter 20 ist auf dem Gehäuse 18 des Elektromotors 10 angebracht und umfasst drei Leistungsmodule 22, welche jeweils einer Phase des Elektromotors 10 zugeordnet sind. Ausgangsseitig sind die Leistungsmodule 22 des Wechselrichters 20 jeweils mit einer Leiterbahn 24, welche vorliegend flachbandartig ausgebildet ist, versehen. Es ist denkbar, dass die Leiterbahnen 24 andere Formen aufweisen. Beispielsweise können die Leiterbahnen 24 jeweils einen runden Querschnitt aufweisen. Die drei Leiterbahnen 24 sind vorliegend mit einem Anschluss 16 des Elektromotors 10 verbunden. Zur Messung von Phasenströmen des Elektromotors 10 umfasst der Wechselrichter 20 drei Stromsensoreinrichtungen 30, die jeweils einer Phase des Elektromotors 10 zugeordnet sind und wie in Figur 2 dargestellt jeweils oberhalb einer der Phasen des Elektromotors 10 zugeordneten Leiterbahn 24 angeordnet und auf dieser angebracht sind. Die Phasenströme des Elektromotors 10 werden durch die jeweils einer Phase des Elektromotors 10 zugeordneten Stromsensoreinrichtungen 30 mittels hochfrequenter Abtastung gemessen. Bevorzugt ist die Abtastungsfrequenz größer als 100 kHz. Zur Verbesserung der Messung der Phasenströme des Elektromotors 10 ist es auch denkbar, dass die Stromsensoreinrichtungen 30 jeweils unterhalb einer den Phasen des Elektromotors 10 zugeordneten Leiterbahn 24 in Richtung des Elektromotors 10 angeordnet werden.

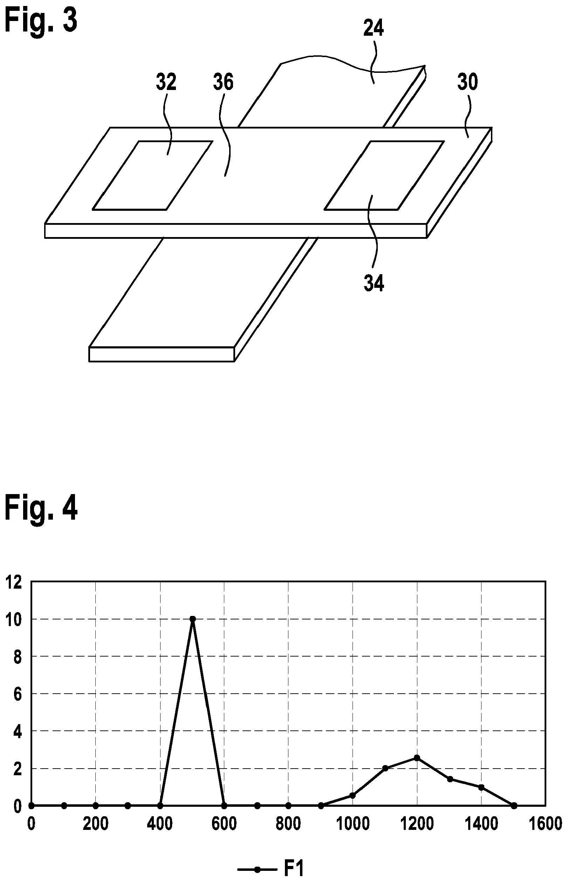

Figur 3 stellt eine Stromsensoreinrichtung 30 aus Figur 2 schematisch dar.

Dabei ist die Stromsensoreinrichtung 30 oberhalb einer der Stromsensoreinrichtung 30 zugeordneten flachbandartigen Leiterbahn 24 angeordnet und auf dieser angebracht. Es ist auch denkbar, dass die Stromsensoreinrichtung 30 unterhalb der Leiterbahn 24 in Richtung des Elektromotors 10 (vgl. Figur 2) angeordnet wird.

Die Stromsensoreinrichtung 30 umfasst eine Platine 36, auf welcher ein erster Magnetfeldsensor 32 und ein zweiter Magnetfeldsensor 34 symmetrisch zu der stromdurchflossenen Leiterbahn 24 angeordnet sind. Mittels der beiden Magnetfeldsensoren 32, 34 werden das Magnetfeld des in der Leiterbahn 24 fließenden Phasenstroms und externe Magnetfelder, wie beispielsweise Erdmagnetfeld oder Magnetfelder, die durch Spulen und/oder Magnete des Elektromotors 10 erzeugt werden, gemessen. Diese externen Magnetfelder werden bei der Strommessung auch als Störfelder bezeichnet, und können durch entsprechenden Algorithmus bei der Messung von Phasenströmen des Elektromotors 10 kompensiert werden.

Die Stromsensoreinrichtung 30 kann ferner Schaltungen zur Auswertung von Messsignalen der mindestens zwei Magnetfeldsensoren 32, 34 und zur Energieversorgung der Stromsensoreinrichtung 30 umfassen.

Die beiden Magnetfeldsensoren 32, 34 können jeweils ein Hallelement aufweisen. Denkbar ist aber auch, dass anstelle von Hallelementen TMR-Elemente oder GMR-Elemente eingesetzt werden.

Die beiden Magnetfeldsensoren 32, 34 messen dabei nur eine Komponente eines Magnetfelds, die senkrecht zu den beiden Magnetfeldsensoren 32, 34 gerichtet ist. Während bei externen Magnetfeldern bzw. Störfeldern die senkrecht zu den beiden Magnetfeldsensoren 32, 34 gerichteten Komponenten in beiden Magnetfeldsensoren 32, 34 den gleichen Betrag und das gleiche Vorzeichen besitzen, haben sie beim Magnetfeld des Phasenstroms des Elektromotors 10 entgegengesetzte Vorzeichen. Durch eine Differenzbildung kann der Phasenstrom des Elektromotors 10 störungsfrei gemessen werden.

Zur Untersuchung, ob ein Fehler beim Elektromotor 10 der elektrischen Antriebseinheit 100 vorliegt, wird zunächst ein zeitlicher Verlauf durch Addieren der Messsignale der beiden Magnetfeldsensoren 32, 34 mindestens einer der Stromsensoreinrichtungen 30 über eine vorbestimmte Anzahl von Umdrehungen des Rotors 12 des Elektromotors 10 erfasst. Das Erdmagnetfeld kann durch eine Filterung eliminiert werden.

Bevorzugt wird der zeitliche Verlauf bei einer günstigen Betriebsbedingung des Elektromotors 10, wie z. B. eine konstante Drehzahl des Elektromotors 10, erfasst.

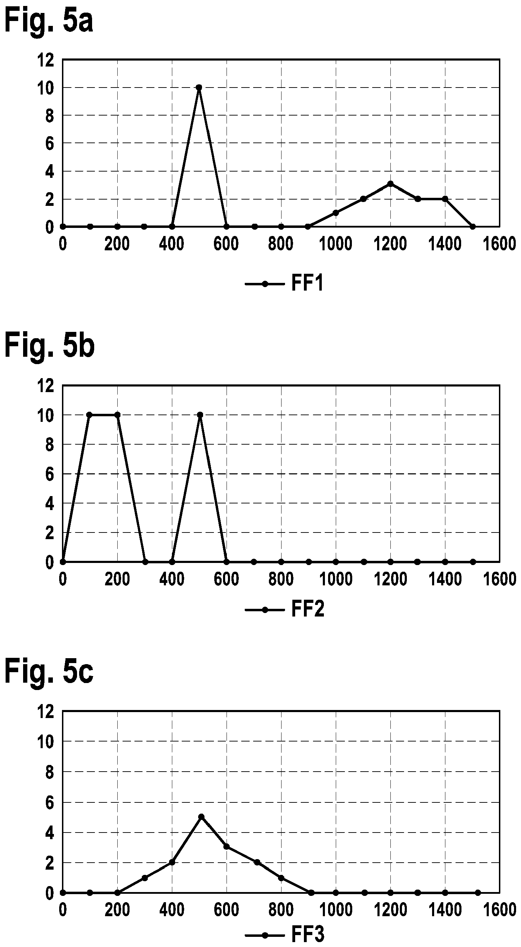

Anschließend wird ein Frequenzspektrum (siehe Figur 4) des durch Addieren der Messsignale der beiden Magnetfeldsensoren 32, 34 erfassten zeitlichen Verlaufs ermittelt. Die Ermittlung des Frequenzspektrums kann beispielsweise über eine Umdrehung des Rotors 12 erfolgen. Danach wird das ermittelte Frequenzspektrum des durch Addieren der Messsignale der beiden Magnetfeldsensoren 32, 34 erfassten zeitlichen Verlaufs mit Frequenzspektren (siehe Figur 5a bis 5c) von typischen Fehlern des Elektromotors 10 verglichen und Ähnlichkeitswerte dazwischen werden ermittelt. Hierbei können beispielsweise Differenzen bei einer gleichen Frequenz zwischen dem ermittelten Frequenzspektrum des durch Addieren der Messsignale der beiden Magnetfeldsensoren 32, 34 erfassten zeitlichen Verlaufs und den Frequenzspektren der typischen Fehler des Elektromotors 10 gebildet werden. Anschließend werden die Ähnlichkeitswerte mit einem vorgegebenen Schwellenwert verglichen. Wenn die Ähnlichkeitswerte kleiner als der vorgegebene Schwellenwert sind, werden Fehler des Elektromotors 10 erkannt.

Die Erfassung des zeitlichen Verlaufs durch Addieren der Messsignale der beiden Magnetfeldsensoren 32, 34 und/oder die Ermittlung des Frequenzspektrums des durch Addieren der Messsignale der beiden Magnetfeldsensoren 32, 34 erfassten zeitlichen Verlaufs können mehrmalig durchgeführt werden und anschließend wird eine Mittelung des Ergebnisses der mehrmaligen Ermittlung des Frequenzspektrums ausgeführt.

Nach Erkennung des Fehlers des Elektromotors 10 können eine oder mehrere Maßnahmen je nach Schwere des Fehlers eingeleitet werden. Beispielsweise kann der Fehler des Elektromotors 10 in einem Fehlerspeicher gespeichert werden. Dabei kann der Fehlerspeicher ein Teil des Steuergeräts des Elektromotors 10 sein. Des Weiteren kann eine Fehlerlampe angesteuert werden und/oder die Drehzahl des Elektromotors 10 reduziert werden.

Der Elektromotor 10 kann eine Bezugsmarke, die beispielsweise als ein Permanentmagnet ausgebildet wird, für eine Messung von Phasenströmen des Elektromotors 10 durch die Stromsensoreinrichtungen 30 und/oder für eine Messung der Drehzahl des Elektromotors 10 aufweisen. Mithilfe der Bezugsmarke kann eine Lageinformation über 360° einer Umdrehung des Rotors 12 erfasst werden. Mit dieser Lageinformation lässt sich feststellen, welche Spule des Stators 14 des Elektromotors 10 oder welcher Magnet des Rotors 12 des als PSM ausgebildeten Elektromotors 10 genau defekt ist.

Figur 4 zeigt ein Beispiel eines Frequenzspektrums F1 eines durch Addieren der Messsignale der beiden Magnetfeldsensoren 32, 34 erfassten zeitlichen Verlaufs und Figuren 5a bis 5c stellen jeweils ein Frequenzspektrum FF1 bis FF3 von typischen Fehlerfällen des Elektromotors 10 dar, welche in einem Steuergerät des Elektromotors 10 gespeichert werden können. Die in Figur 4 und in den Figuren 5a bis 5c dargestellten Diagramme weisen jeweils eine X-Achse und eine Y-Achse auf, wobei auf der X-Achse die Frequenz in Hz und auf der Y-Achse die Amplitude in willkürlichen Einheiten aufgetragen ist.

Beim Vergleich des Frequenzspektrums F1 mit den Frequenzspektren FF1 bis FF3 werden Ähnlichkeitswerte zwischen F1 und FF1 bis FF3 ermittelt. Dabei können beispielsweise Differenzen bei der gleichen Frequenz zwischen F1 und jeweils FF1, FF2 und FF3 gebildet werden. Bei den in Figuren 4 und 5a bis 5c dargestellten Beispielen ist der Ähnlichkeitswert zwischen F1 und FF1 deutlich kleiner als die Ähnlichkeitswerte zwischen F1 und FF2 sowie zwischen F1 und FF3.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Verfahren zur Diagnose eines Elektromotors (10), der einen Rotor (12) und einen Stator (14) aufweist,
wobei ein Wechselrichter (20) ausgangsseitig mit dem Elektromotor (10) elektrisch verbunden ist und Stromsensoreinrichtungen (30) umfasst, die zur Messung von Phasenströmen des Elektromotors (10) jeweils einer Phase des Elektromotors (10) zugeordnet sind,
wobei die Stromsensoreinrichtungen (30) jeweils mindestens zwei Magnetfeldsensoren (32, 34) zur Kompensation von Störfeldern aufweisen,
umfassend folgende Schritte:
- Erfassung eines zeitlichen Verlaufs durch Addieren der Messsignale der mindestens zwei Magnetfeldsensoren (32, 34) von mindestens einer der Stromsensoreinrichtungen (30) über eine vorbestimmte Anzahl von Umdrehungen des Rotors (12) des Elektromotors (10);
- Ermittlung des Frequenzspektrums des durch Addieren der Messsignale der mindestens zwei Magnetfeldsensoren (32, 34) erfassten zeitlichen Verlaufs;
- Ermittlung von Ähnlichkeitswerten zwischen dem ermittelten Frequenzspektrum des durch Addieren der Messsignale der mindestens zwei Magnetfeldsensoren (32, 34) erfassten zeitlichen Verlaufs und den Frequenzspektren der typischen Fehler des Elektromotors (10);
- Erkennung von Fehlern des Elektromotors (10) durch Vergleich der Ähnlichkeitswerte mit einem vorgegebenen Schwellenwert.

2. Verfahren nach Anspruch 1, **dadurch gekennzeichnet, dass** die Erfassung des durch Addieren der Messsignale der mindestens zwei Magnetfeldsensoren (32, 34) erfassten zeitlichen Verlaufs und/oder die Ermittlung des Frequenzspektrums des erfassten zeitlichen Verlaufs unter gleichen Betriebsbedingung des Elektromotors (10) mehrmalig durchgeführt werden und eine Mittelung des Ergebnisses der mehrmaligen Ermittlung des Frequenzspektrums ausgeführt wird.

3. Verfahren nach Anspruch 1 oder 2, **dadurch gekennzeichnet, dass** nach der Erkennung des Fehlers des Elektromotors (10) eine oder mehrere Maßnahmen eingeleitet werden.

4. Verfahren nach einem der Ansprüche 1 bis 3, **dadurch gekennzeichnet, dass**
die mindestens zwei Magnetfeldsensoren (32, 34) der jeweiligen Stromsensoreinrichtungen (30) jeweils mindestens eine Messzelle aufweisen, die als ein Hallelement, ein TMR-Element oder ein GMR-Element ausgebildet ist.

5. Verfahren nach einem der Ansprüche 1 bis 4, **dadurch gekennzeichnet, dass**
der Elektromotor (10) eine Bezugsmarke für eine Messung der Phasenströme des Elektromotors (10) und/oder für eine Messung der Drehzahl des Elektromotors (10) aufweist.

6. Verfahren nach einem der Ansprüche 1 bis 5, **dadurch gekennzeichnet, dass**
eine Änderung und/oder ein Gradient der Änderung des ermittelten Frequenzspektrums des erfassten zeitlichen Verlaufs der Messsignale der mindestens zwei Magnetfeldsensoren (32, 34) ermittelt werden.

7. Verfahren nach einem der Ansprüche 1 bis 6, **dadurch gekennzeichnet, dass**
der Ähnlichkeitswert zwischen dem ermittelten Frequenzspektrum des erfassten zeitlichen Verlaufs der Messsignale der mindestens zwei Magnetfeldsensoren (32, 34) und den Frequenzspektren der typischen Fehler des Elektromotors (10) unter Zuhilfenahme von neuronalen Netzen ermittelt wird.

8. Verfahren nach einem der Ansprüche 1 bis 7, **dadurch gekennzeichnet, dass**
das Frequenzspektrum des erfassten zeitlichen Verlaufs der Messsignale der mindestens zwei Magnetfeldsensoren (32, 34) unter Zuhilfenahme eines Cloud-Servers ermittelt wird.

9. Elektrische Antriebseinheit (100), umfassend einen Elektromotor (10) und einen Wechselrichter (20),
wobei der Wechselrichter (20) ausgangsseitig mit dem Elektromotor (10) elektrisch verbunden ist und Stromsensoreinrichtungen (30) zur Messung von Phasenströmen des Elektromotors (10) aufweist,
wobei die Stromsensoreinrichtungen (30) jeweils einer Phase des Elektromotors (10) zugeordnet sind und jeweils mindestens zwei Magnetfeldsensoren (32, 34) zur Kompensation von Störfeldern umfassen, **dadurch gekennzeichnet, dass**
die elektrische Antriebseinheit (100) zur Durchführung eines Verfahrens nach einem der Ansprüche 1 bis 8 eingerichtet ist.

10. Kraftfahrzeug, welches zur Durchführung eines Verfahrens nach einem der Ansprüche 1 bis 8 eingerichtet ist und/oder das mindestens eine elektrische Antriebseinheit (100) nach Anspruch 9 umfasst.
